(19) **Europäisches Patentamt European Patent Office Office européen des brevets**

(11) **EP 3 367 526 B1**

(12) **EUROPEAN PATENT SPECIFICATION**

(45) Date of publication and mention
of the grant of the patent:
**26.06.2019 Bulletin 2019/26**

(51) Int Cl.:
*H02H 1/00* *(2006.01)*     *G01R 31/40* *(2014.01)*
*H02H 7/20* *(2006.01)*     *H02H 7/122* *(2006.01)*
*H02H 3/42* *(2006.01)*

(21) Application number: **17158089.7**

(22) Date of filing: **27.02.2017**

(54) **METHOD FOR PROTECTING INVERTER ASSEMBLY AGAINST DIRECT CURRENT ARC, AND INVERTER ASSEMBLY**

VERFAHREN ZUM SCHUTZ EINES WECHSELRICHTERS BEI GLEICHSPANNUNGSLICHTBOGEN

PROCÉDÉ DE PROTECTION D'ARC A COURANT CONTINU D'UN INVERSEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**29.08.2018 Bulletin 2018/35**

(73) Proprietor: **ABB Schweiz AG 5400 Baden (CH)**

(72) Inventors:
• **Beck, Christoffer 00380 Helsinki (FI)**
• **Koivula, Ville 00380 Helsinki (FI)**
• **Juvonen, Linda 00380 Helsinki (FI)**

(74) Representative: **Kolster Oy Ab (Salmisaarenaukio 1) P.O. Box 204 00181 Helsinki (FI)**

(56) References cited:
**US-A1- 2012 112 760     US-A1- 2012 134 058
US-A1- 2015 309 104     US-A1- 2015 381 111**

**Description**

FIELD OF THE INVENTION

The present invention relates to protection of an inverter assembly against a direct current arc.

Direct current arcs inside inverter assemblies have severe implications on material and human safety. Detecting a direct current arc inside an inverter assembly by measuring an input current entering the inverter assembly is difficult especially in connection with a solar inverter assembly which is part of a solar power station. Even a maximum short circuit current coming from photovoltaic panels is only about 10% higher than normal operating current. Depending on solar irradiation available at a particular instant of time, a short circuit current coming from photovoltaic panels may be well under normal operating current. Based on above reason, fuses offer no protection for a solar inverter assembly against direct current arc. Prior art systems for arc fault detection in photovoltaic systems are disclosed in the following documents: US2012/0134058, US2012/0112760 and US2015/0381111.

BRIEF DESCRIPTION OF THE INVENTION

An object of the present invention is to provide a reliable method for protecting an inverter assembly against a direct current arc, and an inverter assembly for implementing the method. The objects of the invention are achieved by a method and an inverter assembly which are characterized by what is stated in the independent claims. The preferred embodiments of the invention are disclosed in the dependent claims.

The invention is based on the idea of detecting a direct current arc in an inverter assembly by an arc detection process which comprises comparing an input power and an output power of the inverter assembly in order to determine whether there is an indicative power difference between the input power and the output power. In an embodiment a direct current arc detected by the arc detection process is extinguished by providing a short circuit in direct current side of the inverter assembly by closing a protective switch adapted for said purpose.

An advantage of the method and inverter assembly of the invention is that a direct current arc can be reliably detected even in situations where magnitude of the direct current associated with the arc is small compared with a nominal input current of the inverter assembly.

BRIEF DESCRIPTION OF THE DRAWINGS

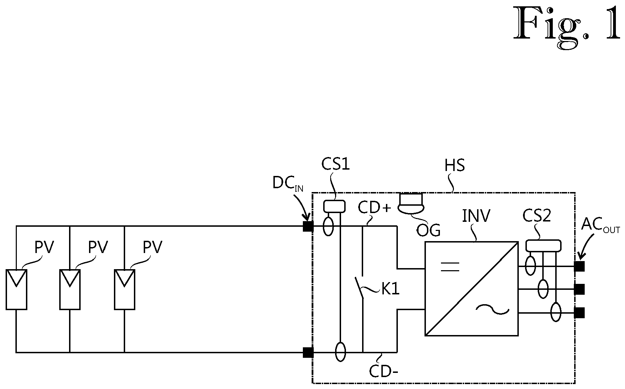

In the following the invention will be described in greater detail by means of preferred embodiments with reference to Figure 1 which shows a solar power station comprising an inverter assembly according to an embodiment of the invention.

DETAILED DESCRIPTION OF THE INVENTION

Figure 1 shows a solar power station comprising a photovoltaic cell system and an inverter assembly. The photovoltaic cell system includes three photovoltaic cells PV adapted to convert the energy of light into direct current. The inverter assembly is adapted to convert direct current generated by the photovoltaic cell system into alternating current.

The inverter assembly comprises an input $DC_{IN}$ adapted to be connected to a direct current supply, an output $AC_{OUT}$ adapted to be connected to an alternating current load, an inverter INV operationally connected between the input $DC_{IN}$ and the output $AC_{OUT}$, a direct current conductor system electrically conductively connecting the input $DC_{IN}$ to the inverter INV, an arc detection system adapted to detect a direct current arc present in the direct current conductor system, and an arc extinguisher system adapted to extinguish a direct current arc present in the direct current conductor system.

The inverter INV is adapted to convert direct current supplied to the inverter assembly through the input $DC_{IN}$ into alternating current, and to supply the alternating current out of the inverter assembly through the output $AC_{OUT}$. The direct current conductor system comprises a positive conductor CD+ and a negative conductor CD-. The positive conductor CD+ comprises a positive busbar, and the negative conductor CD- comprises a negative busbar. When the inverter assembly is in use, there is a direct voltage between the positive conductor CD+ and the negative conductor CD-.

The inverter INV comprises controllable switches for inverting direct current, and controller circuits for controlling the controllable switches. In an embodiment the controllable switches comprise IGBTs.

The arc detection system comprises an input current sensor CS1, an output current sensor CS2 and an optical arc guard OG. The input current sensor CS1 is adapted to measure direct current present in the direct current conductor system. The output current sensor CS2 is adapted to measure alternating current between the inverter INV and the output $AC_{OUT}$. Information provided by the input current sensor CS1 and the output current sensor CS2 is also utilized for controlling the inverter INV. The optical arc guard OG is adapted to optically detect an electric arc present in the direct current conductor system.

An input voltage sensor and output voltage sensor are not depicted in Figure 1. The input voltage sensor is adapted to measure direct voltage present in the input $DC_{IN}$ of the inverter assembly. The output voltage sensor is adapted to measure alternating voltage present in the output $AC_{OUT}$ of the inverter assembly. In an embodiment the input voltage sensor is located at the same location as the input current sensor, and the output voltage sensor is located at the same location as the output current sensor. In alternative embodiments input voltage information and output voltage information is obtained from existing DC-link voltage and AC-voltage measurements needed for basic control of the inverter.

The arc detection system is adapted to detect the direct current arc by means of an arc detection process comprising determining an input power of the inverter assembly, determining an output power of the inverter assembly, comparing the input power and the output power in order to determine whether there is an indicative power difference between the input power and the output power, and detecting the direct current arc if predetermined arc conditions are fulfilled, the predetermined arc conditions include presence of the indicative power difference. The arc detection process is adapted to determine the input power of the inverter assembly using an input current detected by the input current sensor CS1, and an input voltage detected by an input voltage sensor (not depicted). The arc detection process is adapted to determine the output power of the inverter assembly using an output current detected by the output current sensor CS2, and an output voltage detected by an output voltage sensor (not depicted).

In the embodiment of Figure 1 the indicative power difference between the input power and the output power is a function of an operating point of the inverter INV. The indicative power difference is present if inequality below is true.

$$\frac{P_{loss} + P_{AC\_OUT}}{P_{DC\_IN}} < X_{arc}$$

In the inequality above $P_{loss}$ is a power loss of the inverter assembly, $P_{AC\_OUT}$ is an output power of the inverter assembly, $P_{DC\_IN}$ is an input power of the inverter assembly, and $X_{arc}$ is an arc parameter having a value greater than zero but smaller than one. In an embodiment the arc parameter $X_{arc}$ is in the range of $0,9 \leq X_{arc} \leq 0,99$ when the inverter assembly is operating at the nominal power thereof. The arc parameter $X_{arc}$ is a function of an operating point of the inverter assembly because the power loss $P_{loss}$ of the inverter assembly depends on operating point of the inverter INV. Basically, the lower the output power of the inverter, the smaller the arc parameter $X_{arc}$ because relative power losses of the inverter are higher at low power level.

Herein, an operating point of the inverter is a point defined by at least one electrical quantity of the inverter assembly. In an embodiment the at least one electrical quantity of the inverter assembly comprises one or more of the following: an output power of the inverter assembly, an output voltage of the inverter assembly, an output current of the inverter assembly, an output power of the inverter, an output voltage of the inverter, an output current of the inverter.

The power loss $P_{loss}$ of the inverter assembly can be determined in several ways. In an embodiment a power loss of the inverter assembly for a specific operating point is obtained from a table stored in a memory device of the inverter assembly. It is also possible to provide a table containing values of the arc parameter $X_{arc}$ as a function of operating point of the inverter. In another embodiment the power loss $P_{loss}$ of the inverter assembly is calculated in real time with an equation describing power loss of the inverter assembly as a function of operating point. Further, in some embodiments it might be possible to define that the indicative power difference is present if difference between the input power and the output power exceeds a certain percentage of the nominal power of the inverter assembly, the certain percentage being for example 5%.

In an embodiment an indicative power difference is a function of both an operating point of the inverter and duration of power difference between the input power and the output power. In said embodiment the higher the magnitude of the power difference, the shorter the required duration of the power difference for an indicative power difference. For example, a power difference of certain magnitude is interpreted as an indicative power difference if it lasts over required duration, but is not interpreted as an indicative power difference if it lasts less than said required duration. In other words, if duration of a power difference is shorter than required duration, the indicative power difference is not present even if magnitude of the power difference exceeds its limit value.

A duration required for an indicative power difference is in the range of 5ms to 5s. Selecting a small value for the required duration reduces damages caused by a direct current arc to the inverter assembly. Selecting a large value for the required duration reduces system requirements for the arc detection system, and also reduces harmful effects of potential measurement errors relating to the power measurement, the harmful effects including false detection of a direct current arc.

The input current sensor CS1 is located downstream from the input $DC_{IN}$ of the inverter assembly. A distance between the input current sensor CS1 and the input $DC_{IN}$ of the inverter assembly is small. Magnitude of said small distance depends on nominal power of the inverter assembly. In connection with an inverter assembly having nominal power of 100kW, the small distance is less than 20cm, and in connection with an inverter assembly having nominal power of 1MW, the small distance is less than 200cm. The distance between the input current sensor and the input of the inverter assembly is a length of a conductor between the input current sensor and the input of the inverter assembly. In a further alternative embodiment the input current sensor is connected directly to the input of the inverter assembly.

In an embodiment the inverter assembly has multiple inputs wherein each input is adapted to be connected to a separate portion of a photovoltaic cell system, such as a separate photovoltaic cell. In said embodiment the input current sensor can comprise several current sensor units each of which is adapted to measure direct current present in corresponding input, wherein a total input current is the sum of the input currents. Alternatively only one current sensor unit is used, the one current sensor unit being connected to the direct current conductor system downstream a juncture point where the multiple inputs conductively interconnect. The one current sensor unit is placed electrically close to the juncture point.

The closer the input current sensor is located to the input of the inverter assembly the better the arc detection system can detect direct current arcs in the direct current conductor system. If a direct current arc occurs upstream from the input current sensor, the arc detection system is not able to detect the direct current arc because a direct current relating to the arc does not pass through the input current sensor. The upstream direction is a direction from the inverter INV towards the photovoltaic cells PV. In other words the "stream" has a direction of the power flowing from the photovoltaic cell system to the inverter INV.

A direct current arc can occur between the positive conductor CD+ and the negative conductor CD-. A direct current arc can also occur between different components of the inverter assembly. For example, a direct current arc can occur between the positive conductor CD+ and an earthed frame structure of the inverter assembly. The arc detection system is capable of detecting a direct current arc irrespective of components between which the direct current arc occurs.

In addition to the presence of the indicative power difference, the predetermined arc conditions include optical detection performed by the optical arc guard OG. Optical arc guards as such are known in the art. The optical detection is used as a complementary condition in order to confirm a presence of a potential electric arc preliminarily detected by means of the indicative power difference. In an alternative embodiment an inverter assembly does not comprise an optical arc guard, and the predetermined arc conditions consist exclusively of presence of the indicative power difference.

The arc extinguisher system comprises a protective switch K1 adapted to provide a short circuit between the positive conductor CD+ and the negative conductor CD- of the direct current conductor system. The inverter assembly is adapted to close the protective switch K1 as a response to detection of the direct current arc. Closing the protective switch K1 provides a short circuit between the positive conductor CD+ and the negative conductor CD-. Closing the protective switch K1 extinguishes the direct current arc because the short circuit provided by the protective switch K1 reduces voltage between the positive conductor CD+ and the negative conductor CD- close to zero. The reduction of the voltage between the positive conductor CD+ and the negative conductor CD- is detected by normal protection system of the inverter assembly.

The protective switch K1 is located close to the input $DC_{IN}$ of the inverter assembly. A distance between the input $DC_{IN}$ of the inverter assembly and the protective switch K1 is small. The closer the protective switch is to the input of the inverter assembly the smaller portion of the direct current conductor system of the inverter assembly is affected by a short circuit current associated with the direct current arc. Therefore a small distance between the input of the inverter assembly and the protective switch reduces heat generation inside the inverter assembly in case of a direct current arc.

The protective switch K1 is a simple and inexpensive contactor. The protective switch K1 is rated to withstand a full short circuit current while not being rated to disconnect the short circuit current. The full short circuit current is the maximum short circuit current the direct current supply is capable of supplying to the inverter assembly. The capability to disconnect the full short circuit current would substantially increase the price of the protective switch.

After the protective switch K1 is closed, it is kept closed until the short circuit current from the photovoltaic cell system is disconnected by another switch (not depicted), or until the short circuit current disappears for other reasons. In an embodiment said another switch is part of the photovoltaic cell system connected to the inverter assembly. Said other reasons comprise for example nightfall which ends short circuit current from the photovoltaic cell system because the photovoltaic cell system cannot generate electricity during night. Therefore in some embodiments it is possible to close the protective switch and simply wait for the night.

In an alternative embodiment the arc extinguisher system comprises, instead of a switch adapted to short circuit the direct current conductor system, a protective switch which is adapted to extinguish the direct current arc by disconnecting electric current coming from the photovoltaic cell system. However, such a switch capable of disconnecting a short circuit current coming from the photovoltaic cell system is more expensive than a switch only capable of short circuiting the direct current conductor system.

In the embodiment shown in Figure 1 a direct current supply connected to the input $DC_{IN}$ is the photovoltaic cell system, and an alternating current load connected to the output $AC_{OUT}$ is not depicted. In an embodiment the alternating current load is an electrical power network.

The inverter assembly of Figure 1 comprises a housing HS which accommodates the inverter INV, the direct current conductor system, the arc detection system, and the arc extinguisher system. The arc detection system is adapted to detect a direct current arc occurring inside the housing HS, in the direct current conductor system. In an alternative embodiment only part of the above mentioned components are accommodated in the housing of the inverter assembly. In a further alternative embodiment the inverter assembly does not comprise a housing.

In an embodiment the inverter assembly comprises a controller adapted to control functions of the inverter assembly. In said embodiment the controller is adapted to control the inverter, the arc detection system

and the arc extinguisher system. The controller is communicatively connected to the input current sensor and the output current sensor for receiving information from the input current sensor and the output current sensor. The controller is also communicatively connected to all the other sensors of the inverter assembly, and adapted to control all the steps of the method for protecting the inverter assembly against a direct current arc.

In an embodiment the inverter assembly comprises an LCL-filter electrically connected between the inverter and the output of the inverter assembly. Power losses of the LCL-filter are determined and included in power loss of the inverter assembly. In an alternative embodiment the LCL-filter is electrically located downstream from a point where output power of the inverter assembly is determined, wherein it is not necessary to take power losses of the LCL-filter into account in the process of detecting a direct current arc present in the direct current conductor system.

It will be obvious to a person skilled in the art that the inventive concept can be implemented in various ways. The invention and its embodiments are not limited to the examples described above but may vary within the scope of the claims.

**Claims**

1. A method for protecting an inverter assembly against a direct current arc, the inverter assembly comprising:

   an input ($DC_{IN}$) adapted to be connected to a direct current supply;
   an output ($AC_{OUT}$) adapted to be connected to an alternating current load;
   an inverter (INV) operationally connected between the input ($DC_{IN}$) and the output ($AC_{OUT}$), the inverter (INV) is adapted to convert direct current supplied through the input ($DC_{IN}$) into alternating current, and to supply the alternating current to the output ($AC_{OUT}$);
   a direct current conductor system electrically conductively connecting the input ($DC_{IN}$) to the inverter (INV), the direct current conductor system comprising a positive conductor (CD+) and a negative conductor (CD-),
   the method comprising detecting a direct current arc present in the direct current conductor system by means of an arc detection process, and extinguishing the direct current arc detected by the arc detection process,
   **characterized in that** the arc detection process comprises:

   determining an input power of the inverter assembly;
   determining an output power of the inverter assembly;
   comparing the input power and the output power in order to determine whether there is an indicative power difference between the input power and the output power; and
   detecting the direct current arc if predetermined arc conditions are fulfilled, the predetermined arc conditions include presence of the indicative power difference.

2. A method according to claim 1, **characterized in that** the indicative power difference between the input power and the output power is a function of an operating point of the inverter (INV).

3. An inverter assembly for solar power station comprising:

   an input ($DC_{IN}$) adapted to be connected to a direct current supply;
   an output ($AC_{OUT}$) adapted to be connected to an alternating current load;
   an inverter (INV) operationally connected between the input ($DC_{IN}$) and the output ($AC_{OUT}$), the inverter (INV) is adapted to convert direct current supplied through the input ($DC_{IN}$) into alternating current, and to supply the alternating current to the output ($AC_{OUT}$);
   a direct current conductor system electrically conductively connecting the input ($DC_{IN}$) to the inverter (INV), the direct current conductor system comprising a positive conductor (CD+) and a negative conductor (CD-);
   an arc detection system adapted to detect a direct current arc present in the direct current conductor system; and
   an arc extinguisher system adapted to extinguish a direct current arc present in the direct current conductor system,
   **characterized in that** the arc detection system is adapted to detect the direct current arc by means of an arc detection process comprising:

   determining an input power of the inverter assembly;
   determining an output power of the inverter assembly;
   comparing the input power and the output power in order to determine whether there is an indicative power difference between the input power and the output power; and
   detecting the direct current arc if predetermined arc conditions are fulfilled, the predetermined arc conditions include presence of the indicative power difference.

4. An inverter assembly according to claim 3, **characterized in that** the arc detection system comprises an input current sensor (CS1) adapted to measure direct current present in the direct current conductor system, and a distance between the input current sensor and the input ($DC_{IN}$) of the inverter assembly is small.

5. An inverter assembly according to claim 4, **characterized in that** the input current sensor (CS1) is connected directly to the input ($DC_{IN}$) of the inverter assembly.

6. An inverter assembly according to any one of claims 3 to 5, **characterized in that** the arc detection system comprises an optical arc guard (OG) adapted to optically detect an electric arc present in the direct current conductor system, the predetermined arc conditions include optical detection performed by the optical arc guard (OG).

7. An inverter assembly according to any one of claims 3 to 6, **characterized in that** the arc extinguisher system comprises a protective switch (K1) adapted to provide a short circuit between the positive conductor (CD+) and the negative conductor (CD-) of the direct current conductor system.

8. An inverter assembly according to claim 7, **characterized in that** the protective switch (K1) is rated to withstand a full short circuit current while not being rated to disconnect the short circuit current.

9. An inverter assembly according to any one of claims 3 to 8, **characterized in that** the indicative power difference between the input power and the output power is a function of an operating point of the inverter (INV).

10. An inverter assembly according to claim 9, **characterized in that** the indicative power difference is present if

$$\frac{P_{loss}+P_{AC\_OUT}}{P_{DC\_IN}} < X_{arc},$$

wherein $P_{loss}$ is a power loss of the inverter assembly, $P_{AC-OUT}$ is an output power of the inverter assembly, $P_{DC\_IN}$ is an input power of the inverter assembly, and $X_{arc}$ is an arc parameter having a value greater than zero but smaller than one.

11. An inverter assembly according to claim 10, **characterized in that** the power loss (Pioss) of the inverter assembly for a specific operating point is obtained from a table stored in a memory device of the inverter assembly.

12. An inverter assembly according to claim 10, **char-**

**acterized in that** the power loss ($P_{loss}$) of the inverter assembly is calculated in real time with an equation describing the power loss ($P_{loss}$) of the inverter assembly as a function of operating point of the inverter (INV).

13. An inverter assembly according to any one of claims 10 to 12, **characterized in that** the arc parameter ($X_{arc}$) for a specific operating point is obtained from a table stored in a memory device of the inverter assembly.

14. A solar power station comprising:

     a photovoltaic cell system including at least one photovoltaic cell (PV) adapted to convert the energy of light into direct current; and
     an inverter assembly adapted to convert direct current generated by the photovoltaic cell system into alternating current, **characterized in that** the inverter assembly is an inverter assembly according to any one of claims 3 to 13.

## Patentansprüche

1. Verfahren zum Schutz einer Wechselrichteranordnung gegen einen Gleichstromlichtbogen, wobei die Wechselrichteranordnung Folgendes umfasst:

     einen Eingang ($DC_{IN}$), der zum Anschluss an eine Gleichstromversorgung angepasst ist;
     einen Ausgang ($AC_{OUT}$), der zum Anschluss an eine Wechselstromlast angepasst ist;
     einen Wechselrichter (INV), der betriebsmäßig zwischen den Eingang ($DC_{IN}$) und den Ausgang ($AC_{OUT}$) geschaltet ist, wobei der Wechselrichter (INV) angepasst ist zum Umwandeln von durch den Eingang ($DC_{IN}$) zugeführtem Gleichstrom in Wechselstrom und zum Zuführen des Wechselstroms zum Ausgang ($AC_{OUT}$);
     ein Gleichstromleitersystem, das den Eingang ($DC_{IN}$) elektrisch leitend mit dem Wechselrichter (INV) verbindet, wobei das Gleichstromleitersystem einen positiven Leiter (CD+) und einen negativen Leiter (CD-) aufweist,
     wobei das Verfahren das Erfassen eines im Gleichstromleitersystem vorhandenen Gleichstromlichtbogens mittels eines Lichtbogenerfassungsvorgangs und Löschen des durch den Lichtbogenerfassungsvorgang erfassten Gleichstromlichtbogens umfasst, **dadurch gekennzeichnet, dass** der Lichtbogenerfassungsvorgang umfasst:

     Bestimmen einer Eingangsleistung der Wechselrichteranordnung;
     Bestimmen einer Ausgangsleistung der Wechselrichteranordnung;

Vergleichen der Eingangsleistung mit der Ausgangsleistung, um zu bestimmen, ob eine indikative Leistungsdifferenz zwischen der Eingangsleistung und der Ausgangsleistung vorliegt; und

Erfassen des Gleichstromlichtbogens, ob im Voraus bestimmte Lichtbogenbedingungen erfüllt sind, wobei die im Voraus bestimmten Lichtbogenbedingungen das Vorhandensein der indikativen Leistungsdifferenz umfassen.

2. Verfahren nach Anspruch 1, **dadurch gekennzeichnet, dass** die indikative Leistungsdifferenz zwischen der Eingangsleistung und der Ausgangsleistung eine Funktion des Betriebspunkts des Wechselrichters (INV) ist.

3. Wechselrichteranordnung für ein Solarkraftwerk, umfassend:

einen Eingang ($DC_{IN}$), der zum Anschluss an eine Gleichstromversorgung angepasst ist;

einen Ausgang ($AC_{OUT}$), der zum Anschluss an eine Wechselstromlast angepasst ist;

einen Wechselrichter (INV), der betriebsmäßig zwischen den Eingang ($DC_{IN}$) und den Ausgang ($AC_{OUT}$) geschaltet ist, wobei der Wechselrichter (INV) angepasst ist zum Umwandeln von durch den Eingang ($DC_{IN}$) zugeführtem Gleichstrom in Wechselstrom und zum Zuführen des Wechselstroms zum Ausgang ($AC_{OUT}$);

ein Gleichstromleitersystem, das den Eingang ($DC_{IN}$) elektrisch leitend mit dem Wechselrichter (INV) verbindet, wobei das Gleichstromleitersystem einen positiven Leiter (CD+) und einen negativen Leiter (CD-) aufweist;

ein Lichtbogenerfassungssystem, der zum Erfassen eines im Gleichstromleitersystem vorhandenen Gleichstromlichtbogens angepasst ist; und

ein Lichtbogenlöschsystem, der zum Löschen eines im Gleichstromleitersystem vorhandenen Gleichstromlichtbogens angepasst ist,

**dadurch gekennzeichnet, dass** das Lichtbogenerfassungssystem angepasst ist zum Erfassen des Gleichstromlichtbogens mithilfe eines Lichtbogenerfassungsvorgangs, der Folgendes umfasst:

Bestimmen einer Eingangsleistung der Wechselrichteranordnung;

Bestimmen einer Ausgangsleistung der Wechselrichteranordnung;

Vergleichen der Eingangsleistung mit der Ausgangsleistung, um zu bestimmen, ob eine indikative Leistungsdifferenz zwischen der Eingangsleistung und der Ausgangsleistung vorliegt; und

Erfassen des Gleichstromlichtbogens, ob im Voraus bestimmte Lichtbogenbedingungen erfüllt sind, wobei die im Voraus bestimmten Lichtbogenbedingungen das Vorhandensein der indikativen Leistungsdifferenz umfassen.

4. Wechselrichteranordnung nach Anspruch 3, **dadurch gekennzeichnet, dass** das Lichtbogenerfassungssystem einen Eingangsstromsensor (CS1) umfasst, der angepasst ist zum Messen des im Gleichstromleitersystem vorhandenen Gleichstroms, und ein Abstand zwischen dem Eingangsstromsensor und dem Eingang ($DC_{IN}$) der Wechselrichteranordnung klein ist.

5. Wechselrichteranordnung nach Anspruch 4, **dadurch gekennzeichnet, dass** der Eingangsstromsensor (CS1) direkt mit dem Eingang ($DC_{IN}$) der Wechselrichteranordnung verbunden ist.

6. Wechselrichteranordnung nach einem der Ansprüche 3 bis 5, **dadurch gekennzeichnet, dass** das Lichtbogenerfassungssystem einen optischen Lichtbogenschutz (OG) umfasst, der zum optischen Erfassen eines in dem Gleichstromleitersystem vorhandenen elektrischen Lichtbogens angepasst ist, wobei die im Voraus bestimmten Lichtbogenbedingungen ein optisches Erfassen umfassen, das vom optischen Lichtbogenschutz (OG) durchgeführt wird.

7. Wechselrichteranordnung nach einem der Ansprüche 3 bis 6, **dadurch gekennzeichnet, dass** das Lichtbogenlöschsystem einen Schutzschalter (K1) umfasst, der zum Bereitstellen eines Kurzschlusses zwischen dem positiven Leiter (CD+) und dem negativen Leiter (CD-) des Gleichstromleitersystems angepasst ist.

8. Wechselrichteranordnung nach Anspruch 7, **dadurch gekennzeichnet, dass** der Schutzschalter (K1) ausgelegt ist, um einem vollen Kurzschlussstrom standzuhalten, während er nicht dafür ausgelegt ist, den Kurzschlussstrom zu trennen.

9. Wechselrichteranordnung nach einem der Ansprüche 3 bis 8, **dadurch gekennzeichnet, dass** die indikative Leistungsdifferenz zwischen der Eingangsleistung und der Ausgangsleistung eine Funktion des Betriebspunkts des Wechselrichters (INV) ist.

10. Wechselrichteranordnung nach Anspruch 9, **dadurch gekennzeichnet, dass** die indikative Leistungsdifferenz vorliegt, wenn

$$\frac{P_{loss}+P_{AC\_OUT}}{P_{DC\_IN}} < X_{arc},$$

wobei $P_{loss}$ ein Leistungsverlust der Wechselrichter-anordnung, $P_{AC\_OUT}$ eine Ausgangsleistung der Wechselrichteranordnung, $P_{DC\_IN}$ eine Eingangsleistung der Wechselrichteranordnung und $X_{arc}$ ein Bogenparameter mit einem Wert größer als null, aber kleiner als eins.

11. Wechselrichteranordnung nach Anspruch 10, **dadurch gekennzeichnet, dass** die Verlustleistung ($P_{loss}$) der Wechselrichteranordnung für einen bestimmten Betriebspunkt aus einer in einer Speichervorrichtung der Wechselrichteranordnung gespeicherten Tabelle erhalten wird.

12. Wechselrichteranordnung nach Anspruch 10, **dadurch gekennzeichnet, dass** die Verlustleistung ($P_{loss}$) der Wechselrichteranordnung in Echtzeit mit einer Gleichung berechnet wird, die die Verlustleistung ($P_{loss}$) der Wechselrichteranordnung als Funktion des Betriebspunkts des Wechselrichters (INV) beschreibt.

13. Wechselrichteranordnung nach einem der Ansprüche 10 bis 12, **dadurch gekennzeichnet, dass** der Bogenparameter ($X_{arc}$) für einen bestimmten Betriebspunkt aus einer in einer Speichervorrichtung der Wechselrichteranordnung gespeicherten Tabelle erhalten wird.

14. Solarkraftwerk, umfassend:

ein Photovoltaikzellensystem, das mindestens eine Photovoltaikzelle (PV) umfasst, die zum Umwandeln der Energie des Lichts in Gleichstrom angepasst ist; und
eine Wechselrichteranordnung, die zum Um-wandeln von durch das Photovoltaikzellensys-tem erzeugtem Gleichstrom in Wechselstrom angepasst ist, **dadurch gekennzeichnet, dass** die Wechselrichteranordnung eine Wechselrichteranordnung nach einem der Ansprüche 3 bis 13 ist.

**Revendications**

1. Procédé pour protéger un ensemble d'onduleur contre un arc de courant continu, dans lequel l'ensemble d'onduleur comprend :

une entrée ($DC_{IN}$) conçue pour être connectée à une alimentation en courant continu ;
une sortie ($AC_{OUT}$) conçue pour être connectée à une charge de courant alternatif ;

un onduleur (INV) connecté de manière fonctionnelle entre l'entrée ($DC_{IN}$) et la sortie ($AC_{OUT}$), dans lequel l'onduleur (INV) est conçu pour convertir le courant continu fourni à travers l'entrée ($DC_{IN}$) en un courant alternatif, et pour fournir le courant alternatif à la sortie ($AC_{OUT}$) ;
un système de conducteurs de courant continu qui connecte en conduction électrique l'entrée ($DC_{IN}$) à l'onduleur (INV), dans lequel le système de conducteurs de courant continu comprend un conducteur positif (CD+) et un conducteur négatif (CD-),
dans lequel le procédé comprend la détection d'un arc de courant continu présent dans le système de conducteurs de courant continu au moyen d'un processus de détection d'arc, et l'extinction de l'arc de courant continu détecté par le processus de détection d'arc,
**caractérisé en ce que** le processus de détection d'arc comprend :

la détermination d'une puissance d'entrée de l'ensemble d'onduleur ;
la détermination d'une puissance de sortie de l'ensemble d'onduleur ;
la comparaison de la puissance d'entrée et de la puissance de sortie afin de déterminer s'il y a une différence de puissance indicative entre la puissance d'entrée et la puissance de sortie ; et
la détection de l'arc de courant continu si des conditions d'arc prédéterminées sont satisfaites, dans lequel les conditions d'arc prédéterminées comprennent la présence de la différence de puissance indicative.

2. Procédé selon la revendication 1, **caractérisé en ce que** la différence de puissance indicative entre la puissance d'entrée et la puissance de sortie est fonction d'un point de fonctionnement de l'onduleur (INV).

3. Ensemble d'onduleur pour une centrale solaire qui comprend :

une entrée ($DC_{IN}$) conçue pour être connectée à une alimentation en courant continu ;
une sortie ($AC_{OUT}$) conçue pour être connectée à une charge de courant alternatif ;
un onduleur (INV) connecté de manière fonctionnelle entre l'entrée ($DC_{IN}$) et la sortie ($AC_{OUT}$), dans lequel l'onduleur (INV) est conçu pour convertir le courant continu fourni à travers l'entrée ($DC_{IN}$) en un courant alternatif, et pour fournir le courant alternatif à la sortie ($AC_{OUT}$) ;
un système de conducteurs de courant continu qui connecte en conduction électrique l'entrée ($DC_{IN}$) à l'onduleur (INV), dans lequel le système de conducteurs de courant continu comprend un conducteur positif (CD+) et un conducteur négatif (CD-) ;

un système de détection d'arc conçu pour détecter un arc de courant continu présent dans le système de conducteurs de courant continu ; et un système d'extinction d'arc conçu pour éteindre un arc de courant continu présent dans le système de conducteurs de courant continu, **caractérisé en ce que** le système de détection d'arc est conçu pour détecter l'arc de courant continu au moyen d'un processus de détection d'arc qui comprend :

la détermination d'une puissance d'entrée de l'ensemble d'onduleur ;
la détermination d'une puissance de sortie de l'ensemble d'onduleur ;
la comparaison de la puissance d'entrée et de la puissance de sortie afin de déterminer s'il y a une différence de puissance indicative entre la puissance d'entrée et la puissance de sortie ; et
la détection de l'arc de courant continu si des conditions d'arc prédéterminées sont satisfaites, dans lequel les conditions d'arc prédéterminées comprennent la présence de la différence de puissance indicative.

4. Ensemble d'onduleur selon la revendication 3, **caractérisé en ce que** le système de détection d'arc comprend un capteur de courant d'entrée (CS1) conçu pour mesurer le courant continu présent dans le système de conducteurs de courant continu, et une distance entre le capteur de courant d'entrée et l'entrée ($DC_{IN}$) de l'ensemble d'onduleur est faible.

5. Ensemble d'onduleur selon la revendication 4, **caractérisé en ce que** le capteur de courant d'entrée (CS1) est connecté directement à l'entrée ($DC_{IN}$) de l'ensemble d'onduleur.

6. Ensemble d'onduleur selon l'une quelconque des revendications 3 à 5, **caractérisé en ce que** le système de détection d'arc comprend une garde d'arc optique (OG) conçue pour détecter optiquement un arc électrique présent dans le système de conducteurs de courant continu, et les conditions d'arc prédéterminées comprennent la détection optique effectuée par la garde d'arc optique (OG).

7. Ensemble d'onduleur selon l'une quelconque des revendications 3 à 6, **caractérisé en ce que** le système d'extinction d'arc comprend un commutateur de protection (K1) conçu pour réaliser un court-circuit entre le conducteur positif (CD+) et le conducteur négatif (CD-) du système de conducteurs de courant continu.

8. Ensemble d'onduleur selon la revendication 7, **caractérisé en ce que** le commutateur de protection (K1) peut supporter un courant de court-circuit total, sans pouvoir couper le courant de court-circuit.

9. Ensemble d'onduleur selon l'une quelconque des revendications 3 à 8, **caractérisé en ce que** la différence de puissance indicative entre la puissance d'entrée et la puissance de sortie est fonction d'un point de fonctionnement de l'onduleur (INV).

10. Ensemble d'onduleur selon la revendication 9, **caractérisé en ce que** la différence de puissance indicative est présente si

$$\frac{P_{loss} + P_{AC\_OUT}}{P_{DC\_IN}} < X_{arc},$$

où $P_{loss}$ est une perte de puissance de l'ensemble d'onduleur, $P_{AC\_OUT}$ est une puissance de sortie de l'ensemble d'onduleur, $P_{DC\_IN}$ est une puissance d'entrée de l'ensemble d'onduleur, et $X_{arc}$ est un paramètre d'arc qui a une valeur supérieure à zéro mais inférieure à un.

11. Ensemble d'onduleur selon la revendication 10, **caractérisé en ce que** la perte de puissance ($P_{loss}$) de l'ensemble d'onduleur pour un point de fonctionnement spécifique est obtenue à partir d'une table mémorisée dans un dispositif de mémoire de l'ensemble d'onduleur.

12. Ensemble d'onduleur selon la revendication 10, **caractérisé en ce que** la perte de puissance ($P_{loss}$) de l'ensemble d'onduleur est calculée en temps réel avec une équation décrivant la perte de puissance ($P_{loss}$) de l'ensemble d'onduleur en fonction du point de fonctionnement de l'onduleur (INV).

13. Ensemble d'onduleur selon l'une quelconque des revendications 10 à 12, **caractérisé en ce que** le paramètre d'arc ($X_{arc}$) pour un point de fonctionnement spécifique est obtenu à partir d'une table mémorisée dans un dispositif de mémoire de l'ensemble d'onduleur.

14. Centrale solaire qui comprend :

un système de cellule photovoltaïque qui comprend au moins une cellule photovoltaïque (PV) conçue pour convertir l'énergie de la lumière en un courant continu ; et
un ensemble d'onduleur conçu pour convertir le courant continu généré par le système de cellule photovoltaïque en un courant alternatif, **caractérisée en ce que** l'ensemble d'onduleur est un ensemble d'onduleur selon l'une quelconque des revendications 3 à 13.

Fig. 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20120134058 A
- US 20120112760 A
- US 20150381111 A